# EUROPEAN PATENT APPLICATION

(11) **EP 1 172 695 A1**
(43) Date of publication of application: **16.01.2002**
(21) Application number: 01305996.9
(22) Date of filing: 12.07.2001
(51) Int. Cl.: G03F 7/09

(54) **Barrier layer**

(30) Priority: 14.07.2000 US 218235 P
(71) Applicant: Shipley Company LLC, Marlborough, MA 01752 (US)
(72) Inventor: Lachowski, Joseph F., Sutton, Massachusetts 01590 (US); Rutter, Edward W., Jr., Franklin, Massachusetts 02038 (US); Trefonas, Peter, III, Medway, Massachusetts 02053 (US); Pavelchek, Edward K., Stow, Massachusetts 01775 (US)
(74) Representative: Buckley, Guy Julian

(57) **Abstract**

Disclosed are compositions and methods for providing barrier layers for use in electronic device manufacture. Also disclosed are methods of reducing or eliminating poisoning of photoresists during electronic device manufacture.

## Description

### Background of the Invention

The present invention relates generally to the field of manufacture of electronic devices. In particular, the present invention relates to photoresists and antireflective coatings used in the manufacture of electronic devices.

In the manufacture of electronic devices, such as printed wiring boards or semiconductors, a number of layers of material, such as photoresists or antireflective coatings, are applied to a substrate. Photoresists are photosensitive films used for transfer of an image to a substrate. A coating layer of a photoresist is formed on a substrate and the photoresist layer is then exposed through a photomask (reticle) to a source of activating radiation. The photomask has areas that are opaque to activating radiation and other areas that are transparent to activating radiation. Exposure to activating radiation provides a photoinduced chemical transformation of the photoresist coating to thereby transfer the pattern of the photomask to the photoresist coated substrate. Following exposure, the photoresist is developed to provide a relief image that permits selective processing of a substrate.

A photoresist can be either positive-acting or negative-acting. For most negative-acting photoresists, those coating layer portions that are exposed to activating radiation polymerize or cross-link in a reaction between a photoactive compound and polymerizable reagents of the photoresist composition. Consequently, the exposed coating portions are rendered less soluble in a developer solution than unexposed portions. For a positive-acting photoresist, exposed portions are rendered more soluble in a developer solution while areas not exposed remain comparatively less developer soluble. Photoresist compositions are known to the art and described by Deforest, Photoresist Materials and Processes, McGraw Hill Book Company, New York, ch. 2, 1975 and by Moreau, Semiconductor Lithography, Principles, Practices and Materials, Plenum Press, New York, ch. 2 and 4, both incorporated herein by reference to the extent they teach photoresist compositions and methods of making and using them.

A major use of photoresists is in the manufacture of semiconductors where an object is to create features, such as vias, trenches or combinations thereof, in a dielectric layer. Proper photoresist processing is a key to attaining this object. While there is a strong interdependency among the various photoresist processing steps, exposure is believed to be one of the more important steps in attaining high resolution photoresist images.

In such processes, reflection of actinic radiation during exposure of the photoresist and "poisoning" of the photoresist by the dielectric layer are detrimental to fine feature forrnation. Reflection of actinic radiation, such as from the layer underlying the photoresist, often poses limits on resolution of the image patterned in the photoresist layer. Reflection of radiation from the substrate/photoresist interface can produce variations in the radiation intensity in the photoresist during exposure, resulting in non-uniform photoresist linewidth upon development. Radiation also can scatter from the substrate/photoresist interface into regions of the photoresist where exposure is not intended, again resulting in linewidth variations. The amount of scattering and reflection will typically vary from region to region, resulting in further linewidth non-uniformity.

Reflection of activating radiation also contributes to what is known in the art as the "standing wave effect." To eliminate the effects of chromatic aberration in exposure equipment lenses, monochromatic or quasi-monochromatic radiation is commonly used in photoresist projection techniques. Due to radiation reflection at the photoresist/substrate interface, however, constructive and destructive interference is particularly significant when monochromatic or quasi-monochromatic radiation is used for photoresist exposure. In such cases the reflected light interferes with the incident light to form standing waves within the photoresist. In the case of highly reflective substrate regions, the problem is exacerbated since large amplitude standing waves create thin layers of underexposed photoresist at the wave minima. The underexposed layers can prevent complete photoresist development causing edge acuity problems in the photoresist profile. The time required to expose the photoresist is generally an increasing function of photoresist thickness because of the increased total amount of radiation required to expose an increased amount of photoresist. However, because of the standing wave effect, the time of exposure also includes a harmonic component which varies between successive maximum and minimum values with the photoresist thickness. If the photoresist thickness is non-uniform, the problem becomes more severe, resulting in variable linewidths.

With recent trends towards high-density semiconductor devices, there is a movement in the industry to shorten the wavelength of exposure sources to deep ultraviolet (DUV) light (300 nm or less in wavelength), KrF excimer laser light (248 nm), ArF excimer laser light (193 nm), electron beams and soft x-rays. The use of shortened wavelengths of light for imaging a photoresist coating has generally resulted in increased reflection from the upper resist surface as well as the surface of the underlying substrate. Thus, the use of the shorter wavelengths has exacerbated the problems of reflection from a substrate surface.

An approach used to reduce the problem of reflected radiation has been the use of a radiation absorbing layer either interposed between the substrate surface and the photoresist coating layer, called a bottom antireflective coating or BARC, or a radiation layer disposed on the surface of the photoresist layer, called a top antireflective coating or TARC. See, for example, PCT Application WO 90/03598, EPO Application No. 0 639 941 A1 and U.S. Pat. Nos. 4,910,122, 4,370,405 and 4,362,809, all incorporated herein by reference to the extent they teach antireflective (antihalation) compositions and the use of the same. Such BARC and TARC layers have also been generally referred to in the literature as antireflective layers or antireflective compositions. Typically, such antireflective compositions include a radiation absorbing component (or chromophore) a polymeric binder and one or more cross-linking agents. For example, conventional antireflective compositions typically include an epoxy-phenol binder having no free hydroxyl groups or an acrylate binder substantially free of acid groups.

Variations in substrate topography also give rise to resolution-limiting reflection problems. Any image on a substrate can cause impinging radiation to scatter or reflect in various uncontrolled directions, affecting the uniformity of photoresist development. As substrate topography becomes more complex with efforts to design more complex circuits, the effects of reflected radiation become more critical. For example, metal interconnects used on many microelectronic substrates are particularly problematic due to their topography and regions of high reflectivity.

One method of solving such problems resulting from variations in substrate topography is by placing a photoresist at the same height over a surface, as disclosed in U.S. Patent No. 4,557,797 (Fuller et al.). This patent uses a multi-layer structure having a relatively thick bottom layer of poly(methyl methacrylate) ("PMMA") to provide a planar surface, a thin middle layer of an antireflective coating and a thin top layer of a photoresist material. However, this system results in a thick polymer layer which must subsequently be removed. Such layers are typically removed by a variety of methods, such as chemical mechanical polishing ("CMP"), etching and wet chemical methods. Due to the added time and cost of such removal processes, it is desired that the polymer layers be as thin as possible to aid in their subsequent removal.

Another approach to solving the problems associated with variations in substrate topography is that disclosed in Adams et al., *Planarizing AR for DUV Lithography,* Microlithography 1999: Advances in Resist Technology and Processing XVI, Proceedings of SPIE, vol. 3678, part 2, pp 849-856, 1999, which discloses the use of a planarizing antireflective coating, which reduces the need for a separate planarizing layer disposed between the antireflective layer and the substrate.

The use of photoresist layers on dielectric layers often results in "poisoning" of the photoresist layer. This is particularly problematic when the dielectric layer is applied by physical or chemical vapor deposition ("P/CVD") techniques. While the theory of such poisoning is not fully understood, such dielectric layers may cause a significant photospeed shift, lifting, profile degradation or complete dissolution inhibition in previously patterned aperture regions, such as via regions during trench delineation in dual damascene processes. Such poisoning is particularly problematic when positive acting photoresists are used, such as in deep ultraviolet ("DUV") photoresists. While BARCs provide an effective chemical barrier for photoresist layers, such BARCs have not been completely effective in providing a barrier layer against such poisoning by dielectric layers.

There is thus a need to provide effective barriers to the poisoning effect of photoresists by dielectric layers and particularly barrier layers that also provide a planarized surface.

### Summary of the Invention

It has been surprisingly found that the present invention substantially reduces or eliminates the contamination or poisoning effects of photoresist layers by dielectric layers. It has also been surprisingly found that the compositions of the present invention form substantially locally planarized surfaces. It has further been surprisingly found that the present invention substantially reduces or eliminates standing wave effects, bowing, top erosion, and footing.

In one aspect, the present invention provides a barrier composition including one or more cross-linkable polymers, one or more acid catalysts, one or more cross-linking agents and one or more solvents, wherein at least one of the cross-linkable polymers and the cross-linking agent includes one or more acidic moieties.

In a second aspect, the present invention provides a method of providing a barrier layer on a dielectric substrate including the step of disposing on the surface of a dielectric substrate a composition including one or more cross-linkable polymers, one or more acid catalysts, one or more cross-linking agents and one or more solvents, wherein at least one of the cross-linkable polymers and the cross-linking agent includes one or more acidic moieties.

In a third aspect, the present invention provides a device having a dielectric layer and a barrier layer disposed thereon, wherein the barrier layer includes one or more cross-linked polymers including as polymerized units one or more cross-linkable polymers and one or more cross-linking agents, wherein at least one of the cross-linkable polymers and the cross-linking agent includes one or more acidic moieties.

In a fourth aspect, the present invention provides a method of reducing contamination of a photoresist layer including the step of disposing a barrier layer between a dielectric layer and the photoresist layer, the barrier layer including one or more cross-linked polymers including as polymerized units one or more cross-linkable polymers and one or more cross-linking agents, wherein at least one of the cross-linkable polymers and the cross-linking agent includes one or more acidic moieties.

In a fifth aspect, the present invention provides a method for manufacturing an electronic device including the steps of: a) providing a dielectric layer on a substrate; b) disposing on a surface of the dielectric layer a barrier composition including one or more cross-linkable polymers, one or more acid catalysts, one or more cross-linking agents and one or more solvents, wherein at least one of the cross-linkable polymers and the cross-linking agent includes one or more acidic moieties; and c) heating the substrate at a temperature sufficient to at least partially cure the barrier composition to form a barrier layer.

In a sixth aspect, the present invention provides a method for manufacturing an electronic device including the steps of: a) providing a dielectric layer on a substrate; b) disposing on a surface of the dielectric layer a barrier composition including one or more cross-linkable polymers, one or more acid catalysts, one or more cross-linking agents and one or more solvents, wherein at least one of the cross-linkable polymers and the cross-linking agent includes one or more acidic moieties; c) heating the substrate at a temperature sufficient to at least partially cure the barrier composition to form a barrier layer; d) disposing on the surface of the barrier layer an antireflective coating; and e) disposing on the surface of the antireflective coating a photoresist layer.

### Brief Description of the Drawings

Fig. 1 shows a SEM of a cross-sectional image of a contact hole in a dielectric layer formed without the use of a barrier layer.
Fig. 2 shows a SEM of a cross-sectional image of a contact hole in a dielectric layer formed with the use of a 600 Å barrier layer.
Fig. 3 shows a SEM of a cross-sectional image of a contact hole in a dielectric layer formed with the use of a 1000 Å barrier layer.
Fig. 4 shows a SEM of a cross-sectional image of a contact hole in a dielectric layer formed with the use of a 1500 Å barrier layer.
Fig. 5 shows a SEM of a cross-sectional image of a contact hole in a dielectric layer formed with the use of a 2000 Å barrier layer.

### Detailed Description of the Invention

As used throughout this specification, the following abbreviations shall have the following meanings, unless the context clearly indicates otherwise: ° C = degrees Centigrade; g = gram; cm = centimeter; Å = angstroms; rpm = revolutions per minute; %wt = percent by weight; mol% = mole percent; mJ = milliJoules; cm² = square centimerers; L = liter and mL = milliliter.

The term "polymer" refers to dimers, trimers, tetramers, oligomers, homopolymers, copolymers and the like. "Monomer" refers to any ethylenically or acetylenically unsaturated compound capable of being polymerized. The term "(meth)acrylic" includes both acrylic and methacrylic and the term "(meth)acrylate" includes both acrylate and methacrylate. Likewise, the term "(meth)acrylamide" refers to both acrylamide and methacrylamide. "Alkyl" includes straight chain, branched and cyclic alkyl groups. "Cross-linker" and "cross-linking agent" are used interchangeably throughout this specification. "Apertures" refer to vias, trenches, and combinations thereof. "Features" refer to various geometries, including apertures.

All amounts are percent by weight and all ratios are by weight, unless otherwise noted. All numerical ranges are inclusive and combinable.

The present invention is directed to providing a substrate having a dielectric layer, particularly a PVD or CVD deposited dielectric layer, with a barrier layer. The present invention is further directed to reducing or eliminating the poisoning, or contamination, of a photoresist or antireflective coating layer by a dielectric layer. The present invention is particularly suited for use in any electronic device manufacturing process where a photoresist, antireflective coating or both are applied to a dielectric layer substrate.

The compositions of the present invention useful as barrier layer compositions include one or more cross-linkable polymers, one or more acid catalysts, one or more cross-linking agents and one or more solvents, wherein at least one of the cross-linkable polymers and the cross-linking agent includes one or more acidic moieties. "Acidic moieties" refer to one or more acidic groups present on the cross-linkable polymers, cross-linking agents or both. The acidic moieties are at least partially free, preferably substantially free, and more preferably free of blocking groups. The term "free of blocking groups" refers to acidic moieties that have not been functionalized or reacted to form blocked acidic groups, such as ethers or esters. "Substantially free of blocking groups" refers to acidic moieties wherein ≥ 50 % of the acidic groups have not been functionalized or reacted to form blocked acidic groups. It is preferred that ≥ 30 % of the acidic groups have not been functionalized to form blocked acidic groups and more preferably ≥ 20 %. Such acidic moieties include, but are not limited to, carboxylic acids, sulfonic acids, phosphonic acids, hydroxyl compounds such as aromatic hydroxyl compounds, anhydrides and the like. It is preferred that the acidic moieties include aromatic hydroxyl compounds.

It is preferred that the cross-linkable polymers include as polymerized units one or more monomers having acidic moieties, and more preferably one or more aromatic hydroxyl containing monomers. In such cross-linkable polymers, the monomers having acidic moieties are typically present in an amount of from about 1 to about 99 mol%, preferably at least about 3 mol%, more preferably at least about 5 mol%, and even more preferably at least about 10 mol%. Particularly suitable cross-linkable polymers include those having as polymerized units at least about 20, 30, 40, 50, 60, 70, 80 and 90 mol% of monomers having acidic moieties.

The cross-linkable polymers and cross-linking agents having acidic moieties useful in the present invention may also contain other functionality. Suitable other functionality includes, but is not limited to, ester groups, halogen, cyano, (C₁-C₆)alkoxy, and the like. Such polymers and cross-linking agents may also contain more than one acidic moiety, such as, for example, more than one aromatic hydroxyl group or a combination of an aromatic hydroxyl group and a carboxylic acid.

Typically, the cross-linkable polymers have a weight average molecular weight of about 8000 or less, preferably about 5000 or less, and more preferably about 3000 or less. It is also preferred that the cross-linkable polymers have a weight average molecular weight of at least about 300, preferably at least about 400, and more preferably at least about 500. Thus, a particularly useful weight average molecular weight range is from about 300 to about 8000, and more particularly from about 300 to about 5000.

The cross-linkable polymers of the present invention have low molecular weights and broad molecular weight distributions. The molecular weight distributions of the present invention are characterized by the polydispersity of the polymers, i.e. the ratio of the weight average molecular weight to number average molecular weight ("M_{w}/Mₙ"). the polymers of the present invention typically have a value of M_{w}/Mₙ, i.e. polydispersity, of at least 1.5, preferably at least 1.8, more preferably at least 2.0, still more preferably at least 2.5, even more preferably at least 3.0 and most preferably at least 3.5. Typical polydispersities of such cross-linkable polymers are in the range of from 1.5 to 4, preferably 1.8 to 4, and more preferably 2 to 4.

Suitable cross-linkable polymers include, but are not limited to, aromatic-aldehyde condensates and any polymers including as polymerized units one or more hydroxyl group containing monomers such as poly(vinylphenol). The aromatic-aldehyde condensates useful in the present invention include, but are not limited to, phenolic novolak resins. Such novolak resins are typically prepared by condensation of a phenol with an aldehyde and are well known in the art and described in numerous publications including the Kirk Othmer Encyclopedia of Chemical Technology, Volume 15, pages 176 to 208, 1968, incorporated herein by reference to the extent it teaches such resins. Although phenol itself is the commonly used phenol for the formation of such phenolic resins, other hydroxy-substituted aromatic compounds are equally suitable, such as but not limited to resorcinol, alkyl substituted phenols such as naphthols, cresols, xylenols, and p-tert-butylphenol, and bisphenols such as p-phenylphenol and 4,4'-isopropylidenediphenol. Preferred phenols include the cresols, and more preferably m-cresol, mixtures of m- and p-cresol, 2,5-xylenol and mixtures thereof. Mixtures of hydroxy-substituted aromatic compounds may be advantageously used in the present invention.

The aldehyde used is typically formaldehyde, but other aldehydes such as but not limited to acetaldehyde, furfuraldehyde and aromatic aldehydes may be used. Preferred aromatic aldehydes are those where a hydroxyl group is in a position ortho to the carbonyl group. Most preferred aromatic aldehydes are salicylaldehyde, benzaldehyde and mixtures thereof. Other aromatic aldehydes suitable for purposes of the invention include 2-chlorobenzaldehyde, 3-hydroxybenzaldehyde, 4-hydroxybenzaldehyde, 2-methoxybenzaldehyde, 3-nitrobenzaldehyde, and the like. Mixtures of aldehydes may be advantageously used in the present invention. When an aromatic aldehyde is mixed with formaldehyde or a formaldehyde precursor such as paraformaldehyde, the aromatic aldehyde preferably is in molar excess of formaldehyde, and more preferably at least 90% by weight of the aldehyde mixture.

Typically, the phenol novolak resins are formed by condensing the phenol, i.e. hydroxy-substituted aromatic compound, with the aldehyde in the presence of acid. The molar concentration of the aldehyde may be slightly less than that of the phenol, but may also be equivalent to or slightly in excess of the phenol without formation of a crosslinked resin. In this respect, the ratio of the phenol to the aldehyde may vary between about 1.1 to 1.0 and 1.0 to 1.1 See, for example, U.S. Patent No. 5,939,511 (Zampini et al.).

In general, the polydispersity of such aromatic-aldehyde condensates useful as cross-linkable polymers in the present invention is at least about 2.5, preferably at least about 3.0 and more preferably at least about 3.5.

Any hydroxyl group containing ethylenically or acetylenically unsaturated compound is useful as the hydroxyl group containing monomer in the present invention. Such hydroxy group containing monomers may be aliphatic or aromatic, and preferably aromatic. Suitable hydroxy group containing monomers include, but are not limited to, phenol, cresol, resorcinol, pyrogallol, methylol phenol, methylol cresol, methylol resorcinol, methylol pyrogallol, hydroxyethylphenol, hydroxypropylphenol, hydroxyethylcresol, vinyl phenol, vinyl cresol, vinyl methoxy phenol, hydroxyethyl (meth)acrylate, 2-hydroxypropyl (meth)acrylate, 3-hydroxypropyl (meth)acrylate, hydroxycyclohexyl (meth)acrylate, hydroxyphenyl (meth)acrylate, di-ethyleneglycol (meth)acrylate, bis(hydroxyethyl) itaconate, bis(hydroxyethyl) citraconate, bis(hydroxyethyl) fumarate, hydroxyethyl itaconate, allyl phenol, allyl methoxy phenol, allyl alcohol, vinyl alcohol, and the like.

It is preferred that the cross-linkable polymers of the present invention include as polymerized units one or more aromatic compounds, such as at least about 3 mol%, preferably at least about 5 mol%, and more preferably at least about 10 mol%. Preferred aromatic compounds include, but are not limited to, phenolic compounds, cresolic compounds, resorcinolic compounds, xylenolic compounds and the like. Particularly useful cross-linkable polymers include those containing at least about 20 mol% aromatic compounds as polymerized units. It is further preferred that the cross-linkable polymers include one or more aromatic-aldehyde condensates.

Particularly useful cross-linkable polymers include one or more aromatic-aldehyde condensates and one or more other polymers, such as (meth)acrylate polymers, wherein the value of M_{w}/Mₙ for the aromatic-aldehyde condensates is at least 2.5, and preferably at least 3.0. An advantage of including a non-aromatic polymer, such as a (meth)acrylate polymer, with the aromatic-aldehyde condensates is that the etch rate of the barrier composition may be increased. It is still further preferred that the cross-linkable polymers of the present invention are substantially free of silphenylene moieties, and more preferably free of silphenylene moieties.

Other monomers useful in preparing the cross-linkable polymers of the present invention include, but are not limited to, (meth)acrylic acid, (meth)acrylamides, alkyl (meth)acrylates, alkenyl (meth)acrylates, aromatic (meth)acrylates, vinyl aromatic monomers, nitrogen-containing compounds and their thio-analogs, substituted ethylene monomers, and the like. Particularly suitable cross-linkable polymers useful in the present invention include mixtures of aromatic-aldehyde condensates, particularly novolak resins, with one or more or poly((meth)acrylic acid), poly((meth)acrylamide), poly(alkyl (meth)acrylate), poly(alkenyl (meth)acrylate), poly(aromatic (meth)acrylate), and poly(vinyl aromatic).

Typically, the alkyl (meth)acrylates useful in the present invention are (C₁-C₂₄) alkyl (meth)acrylates. Suitable alkyl (meth)acrylates include, but are not limited to, "low cut" alkyl (meth)acrylates, "mid cut" alkyl (meth)acrylates and "high cut" alkyl (meth)acrylates.

"Low cut" alkyl (meth)acrylates are typically those where the alkyl group contains from 1 to 6 carbon atoms. Suitable low cut alkyl (meth)acrylates include, but are not limited to: methyl methacrylate ("MMA"), methyl acrylate, ethyl acrylate, propyl methacrylate, butyl methacrylate ("BMA"), butyl acrylate ("BA"), isobutyl methacrylate ("IBMA"), hexyl methacrylate, cyclohexyl methacrylate, cyclohexyl acrylate and mixtures thereof.

"Mid cut" alkyl (meth)acrylates are typically those where the alkyl group contains from 7 to 15 carbon atoms. Suitable mid cut alkyl (meth)acrylates include, but are not limited to: 2-ethylhexyl acrylate ("EHA"), 2-ethylhexyl methacrylate, octyl methacrylate, decyl methacrylate, isodecyl methacrylate ("IDMA", based on branched (C₁₀)alkyl isomer mixture), undecyl methacrylate, dodecyl methacrylate (also known as lauryl methacrylate), tridecyl methacrylate, tetradecyl methacrylate (also known as myristyl methacrylate), pentadecyl methacrylate and mixtures thereof. Particularly useful mixtures include dodecyl-pentadecyl methacrylate ("DPMA"), a mixture of linear and branched isomers of dodecyl, tridecyl, tetradecyl and pentadecyl methacrylates; and lauryl-myristyl methacrylate ("LMA").

"High cut" alkyl (meth)acrylates are typically those where the alkyl group contains from 16 to 24 carbon atoms. Suitable high cut alkyl (meth)acrylates include, but are not limited to: hexadecyl methacrylate, heptadecyl methacrylate, octadecyl methacrylate, nonadecyl methacrylate, cosyl methacrylate, eicosyl methacrylate and mixtures thereof. Particularly useful mixtures of high cut alkyl (meth)acrylates include, but are not limited to: cetyl-eicosyl methacrylate ("CEMA"), which is a mixture of hexadecyl, octadecyl, cosyl and eicosyl methacrylate; and cetyl-stearyl methacrylate ("SMA"), which is a mixture of hexadecyl and octadecyl methacrylate.

The mid-cut and high-cut alkyl (meth)acrylate monomers described above are generally prepared by standard esterification procedures using technical grades of long chain aliphatic alcohols, and these commercially available alcohols are mixtures of alcohols of varying chain lengths containing between 10 and 15 or 16 and 20 carbon atoms in the alkyl group. Examples of these alcohols are the various Ziegler catalyzed ALFOL alcohols from Vista Chemical company, i.e., ALFOL 1618 and ALFOL 1620, Ziegler catalyzed various NEODOL alcohols from Shell Chemical Company, i.e. NEODOL 25L, and naturally derived alcohols such as Proctor & Gamble's TA-1618 and CO-1270. Consequently, for the purposes of this invention, alkyl (meth)acrylate is intended to include not only the individual alkyl (meth)acrylate product named, but also to include mixtures of the alkyl (meth)acrylates with a predominant amount of the particular alkyl (meth)acrylate named.

The alkyl (meth)acrylate monomers useful in the present invention may be a single monomer or a mixture having different numbers of carbon atoms in the alkyl portion. Also, the (meth)acrylamide and alkyl (meth)acrylate monomers useful in the present invention may optionally be substituted. Suitable optionally substituted (meth)acrylamide and alkyl (meth)acrylate monomers include, but are not limited to: hydroxy (C₂-C₆)alkyl (meth)acrylates, dialkylamino(C₂-C₆)-alkyl (meth)acrylates, dialkylamino(C₂-C₆)alkyl (meth)acrylamides.

Particularly useful substituted alkyl (meth)acrylate monomers are those with one or more hydroxyl groups in the alkyl radical, especially those where the hydroxyl group is found at the β-position (2-position) in the alkyl radical. Hydroxyalkyl (meth)acrylate monomers in which the substituted alkyl group is a (C₂-C₆)alkyl, branched or unbranched, are preferred. Suitable hydroxyalkyl (meth)acrylate monomers include, but are not limited to: 2-hydroxyethyl methacrylate ("HEMA"), 2-hydroxyethyl acrylate ("HEA"), 2-hydroxypropyl methacrylate, 1-methyl-2-hydroxyethyl methacrylate, 2-hydroxy-propyl acrylate, 1-methyl-2-hydroxyethyl acrylate, 2-hydroxybutyl methacrylate, 2-hydroxybutyl acrylate and mixtures thereof. The preferred hydroxyalkyl (meth)acrylate monomers are HEMA, 1-methyl-2-hydroxyethyl methacrylate, 2-hydroxypropyl methacrylate and mixtures thereof. A mixture of the latter two monomers is commonly referred to as "hydroxypropyl methacrylate" or "HPMA."

Other substituted (meth)acrylate and (meth)acrylamide monomers useful in the present invention are those with a dialkylamino group or dialkylaminoalkyl group in the alkyl radical. Examples of such substituted (meth)acrylates and (meth)acrylamides include, but are not limited to: dimethylaminoethyl methacrylate, dimethylaminoethyl acrylate, N,N-dimethylaminoethyl methacrylamide, N,N-dimethyl-aminopropyl methacrylamide, N,N-dimethylaminobutyl methacrylamide, N,N-di-ethylaminoethyl methacrylamide, N,N-diethylaminopropyl methacrylamide, N,N-diethylaminobutyl methacrylamide, N-(1,1-dimethyl-3-oxobutyl) acrylamide, N-(1,3-diphenyl-1-ethyl-3-oxobutyl) acrylamide, N-(1-methyl-1-phenyl-3-oxobutyl) methacrylamide, and 2-hydroxyethyl acrylamide, N-methacrylamide of aminoethyl ethylene urea, N-methacryloxy ethyl morpholine, N-maleimide of dimethylaminopropylamine and mixtures thereof.

Other substituted (meth)acrylate monomers useful in the present invention are silicon-containing monomers such as γ-propyl tri(C₁-C₆)alkoxysilyl (meth)acrylate, γ-propyl tri(C₁-C₆)alkylsilyl (meth)acrylate, γ-propyl di(C₁-C₆)alkoxy(C₁-C₆)alkylsilyl (meth)acrylate, γ-propyl di(C₁-C₆)alkyl(C₁-C₆)alkoxysilyl (meth)acrylate, vinyl tri(C₁-C₆)alkoxysilyl (meth)acrylate, vinyl di(C₁-C₆)alkoxy(C₁-C₆)alkylsilyl (meth)acrylate, vinyl (C₁-C₆)alkoxydi(C₁-C₆)alkylsilyl (meth)acrylate, vinyl tri(C₁-C₆)alkylsilyl (meth)acrylate, and mixtures thereof.

The vinylaromatic monomers useful as unsaturated monomers in the present invention include, but are not limited to: styrene ("STY"), α-methylstyrene, vinyltoluene, *p*-methylstyrene, ethylvinylbenzene, vinylnaphthalene, vinylxylenes, and mixtures thereof. The vinylaromatic monomers also include their corresponding substituted counterparts, such as halogenated derivatives, i.e., containing one or more halogen groups, such as fluorine, chlorine or bromine; and nitro, cyano, (C₁-C₁₀)alkoxy, halo(C₁-C₁₀)alkyl, carb(C₁-C₁₀)alkoxy, carboxy, amino, (C₁-C₁₀)alkylamino derivatives and the like.

The nitrogen-containing compounds and their thio-analogs useful as unsaturated monomers in the present invention include, but are not limited to: vinylpyridines such as 2-vinylpyridine or 4-vinylpyridine; lower alkyl (C₁-C₈) substituted N-vinyl pyridines such as 2-methyl-5-vinyl-pyridine, 2-ethyl-5-vinylpyridine, 3-methyl-5-vinylpyridine, 2,3-dimethyl-5-vinyl-pyridine, and 2-methyl-3-ethyl-5-vinylpyridine; methyl-substituted quinolines and isoquinolines; N-vinylcaprolactam; N-vinylbutyrolactam; N-vinylpyrrolidone; vinyl imidazole; N-vinyl carbazole; N-vinyl-succinimide; (meth)acrylonitrile; *o-, m-,* or *p*-aminostyrene; maleimide; N-vinyl-oxazolidone; N,N-dimethyl aminoethyl-vinyl-ether; ethyl-2-cyano acrylate; vinyl acetonitrile; N-vinylphthalimide; N-vinyl-pyrrolidones such as N-vinyl-thio-pyrrolidone, 3 methyl-1-vinyl-pyrrolidone, 4-methyl-1-vinyl-pyrrolidone, 5-methyl-1-vinyl-pyrrolidone, 3-ethyl-1-vinyl-pyrrolidohe, 3-butyl-1-vinyl-pyrrolidone, 3,3-dimethyl-1-vinyl-pyrrolidone, 4,5-dimethyl-1-vinyl-pyrrolidone, 5,5-dimethyl-1-vinyl-pyrrolidone, 3,3,5-trimethyl-1-vinylpyrrolidone, 4-ethyl-1-vinyl-pyrrolidone, 5-methyl-5-ethyl-1-vinyl-pyrrolidone and 3,4,5-trimethyl-1-vinyl-pyrrolidone; vinyl pyrroles; vinyl anilines; and vinyl piperidines.

The substituted ethylene monomers useful as unsaturated monomers in the present invention include, but are not limited to: allylic monomers, vinyl acetate, vinyl formamide, vinyl chloride, vinyl fluoride, vinyl bromide, vinylidene chloride, vinylidene fluoride and vinylidene bromide.

Cross-linkable polymers are present in the compositions of the invention across a wide range of amounts. Typically, the cross-linkable polymers are present in amounts of from about 40 to about 85 % of solids, and preferably from about 60 to about 85 % of solids.

Cross-linkers useful in the present invention are any which undergo acid catalyzed cross-linking with the cross-linkable polymers. Typically, the cross-linkers of the present invention have a molecular weight of about 120 Daltons or greater. It is preferred that the cross-linkers undergo cross-linking reactions a temperature from about 75° C to about 250° C. Suitable cross-linkers include di-, tri-, tetra-, or higher multifunctional ethylenically unsaturated monomers. Examples of cross-linkers useful in the present invention include, but are not limited to: trivinylbenzene, divinyltoluene, divinylpyridine, divinylnaphthalene and divinylxylene; and such as ethyleneglycol diacrylate, trimethylolpropane triacrylate, diethyleneglycol divinyl ether, trivinylcyclohexane, allyl methacrylate ("ALMA"), ethyleneglycol dimethacrylate ("EGDMA"), diethyleneglycol dimethacrylate ("DEGDMA"), propyleneglycol dimethacrylate, propyleneglycol diacrylate, trimethylolpropane trimethacrylate ("TMPTMA"), divinyl benzene ("DVB"), glycidyl methacrylate, 2,2-dimethylpropane 1,3 diacrylate, 1,3-butylene glycol diacrylate, 1,3-butylene glycol dimethacrylate, 1,4-butanediol diacrylate, diethylene glycol diacrylate, diethylene glycol dimethacrylate, 1,6-hexanediol diacrylate, 1,6-hexanediol dimethacrylate, tripropylene glycol diacrylate, triethylene glycol dimethacrylate, tetraethylene glycol diacrylate, polyethylene glycol 200 diacrylate, tetraethylene glycol dimethacrylate, polyethylene glycol dimethacrylate, ethoxylated bisphenol A diacrylate, ethoxylated bisphenol A dimethacrylate, polyethylene glycol 600 dimethacrylate, poly(butanediol) diacrylate, pentaerythritol triacrylate, trimethylolpropane triethoxy triacrylate, glyceryl propoxy triacrylate, pentaerythritol tetraacrylate, pentaerythritol tetramethacrylate, dipentaerythritol monohydroxypentaacrylate, divinyl silane, trivinyl silane, dimethyl divinyl silane, divinyl methyl silane, methyl trivinyl silane, diphenyl divinyl silane, divinyl phenyl silane, trivinyl phenyl silane, divinyl methyl phenyl silane, tetravinyl silane, dimethyl vinyl disiloxane, poly(methyl vinyl siloxane), poly(vinyl hydro siloxane), poly (phenyl vinyl siloxane), tetra(C₁-C₈)alkoxyglycoluril such as tetramethoxyglycoluril and tetrabutoxyglycoluril, and mixtures thereof.

The cross-linkers of the present invention may be used in the compositions of the present invention in a wide range of concentrations. Typically, the cross-linkers are present in amounts of from about 1 to about 30 % of solids, preferably from about 10 to about 25 % of solids, and more preferably from about 15 to about 25 % of solids.

The acid catalysts useful in the present invention are any which are capable of catalyzing the cross-linking reaction of the barrier layer compositions of the present invention and include free acids and acid generators. Examples of free acids include, but are not limited to, sulfonic acids such as methane sulfonic acid, ethane sulfonic acid, propyl sulfonic acid, phenyl sulfonic acid, toluene sulfonic acid, dodecylbenzene sulfonic acid, and trifluoromethyl sulfonic acid.

The acid generators include thermal acid generators ("TAGs"), photoacid generators ("PAGs") and mixtures thereof. Any thermal acid generator and any photoacid generator are useful in the present invention. A thermal acid generator is any compound that liberates acid upon thermal treatment. Suitable thermal acid generators include, but are not limited to, 2,4,4,6-tetrabromocyclohexadienone, benzoin tosylate, 2-nitrobenzyl tosylate, other alkyl esters of organic sulfonic acids and amine salts of sulfonic acids, such as amine salts of dodecyl benzene sulfonic acid. Compounds that generate a sulfonic acid upon activation, i.e. exposure to heat, are generally suitable. Photoacid generators are compounds that liberate acid upon photolysis. Suitable photoacid generators include, but are not limited to, onium salts and halogenated non-ionic photoacid generators such as 1,1-bis(p-chlorophenyl)-2,2,2-trichloroethane and fluoroalkylsulfonic acids, such as perfluorooctylsulfonic acid.

The acid catalysts are typically present in the compositions of the present invention in an amount sufficient to catalyze the desired cross-linking reactions, such as from about 0.1 to about 8 % of solids, and preferably from about 0.5 to about 5 % of solids. It is preferred that a combination of acid catalysts is used in the present invention. Suitable combinations include a free acid with a photoacid generator and a free acid with a thermal acid generator. Such acid catalysts are generally known or commercially available and may be used without further purification.

The compositions of the present invention contain one or more solvents. Any solvent that is compatible with the formulation is suitable. Solvents having low viscosity are preferred. Suitable solvents include, but are not limited to, propylene glycol methyl ether acetate, 2-heptanone, ethyl lactate or one or more of the glycol ethers such as 2-methoxyethyl ether (diglyme), ethylene glycol monomethyl ether, and propylene glycol monomethyl ether; solvents that have both ether and hydroxy moieties such as methoxy butanol, ethoxy butanol, methoxy propanol and ethoxy propanol; esters such as methyl cellosolve acetate, ethyl cellosolve acetate, propylene glycol monomethyl ether acetate, dipropylene glycol monomethyl ether acetate and other solvents such as dibasic esters, propylene carbonate and gamma-butyrolactone. Particularly suitable solvents useful in the present invention are relatively high boiling, i.e. such solvents have boiling points at least about 170° C, and preferably at least about 190° C. Mixtures of solvents may be advantageously used in the present invention. Thus, the solvents of the present invention may be admixed with one or more other solvents. Such other solvents may be high boiling or low boiling. When two or more solvents are used, it is preferred that at least one solvent has a boiling point in the range of from about 75° to about 200° C. It is further preferred that when two or more solvents are used, that at least one solvent has a boiling point of less than about 200° C and at least one other solvent has a boiling point greater than about 200° C.

The compositions of the present invention may optionally include one or more other components, such as, but not limited to, plasticizers, surfactants, leveling agents, dyes, pigments, chromophores, and the like.

Plasticizers may be added to the compositions of the present invention to improve certain characteristics of the compositions. Suitable plasticizers include, but are not limited to, dibasic esters such as dimethyl adipate and dimethyl succinate. Mixtures of plasticizers may be used in the present invention. Typically, the plasticizers are used in an amount of from about 0.5 to about 10 % of solids, and preferably from about 1 to about 5 % of solids. It is preferred that one or more plasticizers are used in the compositions of the present invention. It will be appreciated by those skilled in the art that higher amounts of plasticizers, such as up to about 50 to about 100 % of solids, may be advantageously used in the present invention. It is preferred that the plasticizer is a liquid.

Optional surfactants include, but are not limited to, nonionic surfactants, cationic surfactants and mixtures thereof. Particularly suitable surfactants are fluorinated surfactants, such as those available from the 3M Company. Surfactants are typically used in an amount of from about 0.1 to about 1.0 %wt.

The leveling agents useful in the present invention are surface leveling agents such as those available under the tradename SILWET 7604 from Witco, or the surfactant FC 430 available from the 3M Company. The choice and amount of such leveling agent is within the ability of one skilled in the art. Typically, such leveling agents are used in an amount of from about 0.1 to about 2 % of total solids.

The compositions of the present invention may also function as antireflective coatings. For example, when the cross-linkable polymer and/or the cross-linking agent contains aromatic groups, such compositions may be used as an antireflective composition for 193 nm radiation. In the alternative, dyes or chromophores may be added to the compositions of the present invention, such as by copolymerization or admixture with, to provide antireflective compositions useful at other wavelengths of radiation. For example, the cross-linkable polymer and/or cross-linking agent may contain sufficient chromophore groups to yield an optical density of from about 0.3 to about 0.8 at the exposure wavelength used for subsequently applied photoresist layers. In the alternative, a chromophore such as an anthracene compound, may be added directly to the present compositions.

The concentration of the dry components, i.e. one or more cross-linkable polymers, one or more acid catalysts and one or more cross-linking agents, in the solvent will depend on several factors such as the method of application. In general, the solids content of the compositions of the present invention include from about 0.5 to 25 weight percent of the total weight of the composition, preferably the solids content varies from about 2 to 20 weight percent of the total weight of the composition. The compositions of the present invention are prepared by combining the components in any order.

The compositions of the present invention are useful as a barrier layer on a substrate, particularly dielectric layer substrates, in the manufacture of electronic devices, such as semiconductors, conductors, integrated circuits, printed wiring boards, and the like. The compositions of the present invention are particularly useful in the manufacture of semiconductor devices such as wafers used in the manufacture of semiconductors. The compositions of the present invention may be applied to the substrate by any of a variety of means, such as by spin coating. When applied to a substrate, the compositions of the present invention provide a coating or layer disposed on the surface of the substrate. When the compositions are applied by spin coating, such as to a semiconductor wafer, the thickness of the resulting film can be controlled, such as from about <200 Å to about 1.5 µm, and preferably from about 200 Å to about 1.5 µm. Typically, the barrier compositions of the present invention are applied in layers of from about 600 to about 1600 Å, and preferably from about 600 to about 1200 Å.

Thus, the present invention provides a method of providing a barrier layer on a dielectric substrate including the step of disposing on the surface of a dielectric substrate a composition including one or more cross-linkable polymers, one or more acid catalysts, one or more cross-linking agents and one or more solvents, wherein at least one of the cross-linkable polymers and the cross-linking agent includes one or more acidic moieties. The barrier layers of the present invention may be advantageously used to reduce or eliminate the contamination of any photoresist or antireflective coating by any dielectric layer, preferably PVD or CVD deposited dielectric layers. Suitable dielectric layers include inorganic dielectric layers, organic dielectric layers and mixtures thereof, and preferably inorganic dielectric layers. Suitable inorganic dielectric layers include, but are not limited to, silicon containing dielectric materials such as silica, silsesquioxanes, partially condensed alkoxysilanes, organically modified silicates, and the like. Various organic dielectric materials may also be used in the present invention.

Typically, the compositions of the present invention are at least partially cured by heating at a temperature of from about 75° to about 250° C, preferably from about 90° to about 225° C. "At least partially cured" refers to at least about 10% cross-linking of the barrier composition. It is preferred that the barrier composition is substantially cross-linked and more preferably fully crosslinked. The compositions of the present invention may be cured by subjecting a substrate coated with the composition to a one-step or two-step bake. A one-step bake heats the compositions of the present invention at a temperature and for a period of time sufficiently to at least partially, and preferably substantially, cross-link the composition. In the alternative, a two-step bake may be used which heats the compositions of the present invention at a first temperature which is not sufficient to cure the compositions but allows the compositions to reflow to improve planarization, followed by heating at a second temperature and for a period of time sufficiently to at least partially, and preferably substantially, cross-link the composition.

In general, the compositions of the present invention are cured from about 15 to about 360 seconds, preferably from about 15 to about 120 seconds, more preferably from about 30 to about 120 seconds, and even more preferably about 60 seconds. It will be appreciated by those skilled in the art that the specific curing time will depend upon the specific cross-linking agent, amount of cross-linking agent, amount of acid catalyst, heating temperature, among others

Thus, the present invention also provides substrates or devices having a dielectric layer and a barrier layer disposed thereon, wherein the barrier layer includes one or more cross-linked polymers including as polymerized units one or more cross-linkable polymers and one or more cross-linking agents, wherein at least one of the cross-linkable polymers and the cross-linking agent includes one or more acidic moieties. It is preferred that in such devices that a photoresist layer is disposed on the barrier layer. It is further preferred that an antireflective composition is disposed between the barrier layer and the photoresist layer.

In the manufacture of electronic devices, particularly semiconductor wafers, dielectric layers are often applied, such as by physical vapor deposition ("PVD") or chemical vapor deposition ("CVD"). These dielectric layers need to be patterned for subsequent etching and metallization steps. Such patterning is achieved through the use of photoresists, often in conjunction with antireflective coatings. The application of a layer of a barrier composition of the present invention prior to the application of the photoresist layer, and preferably prior to the application of an antireflective coating, greatly reduces or eliminates poisoning or contamination of the photoresist layer by the dielectric layer.

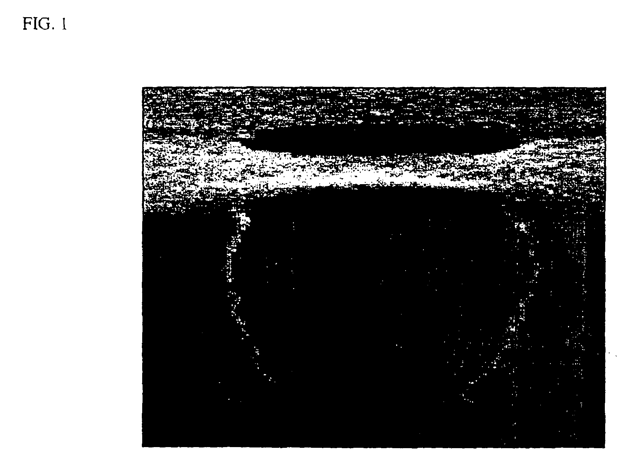

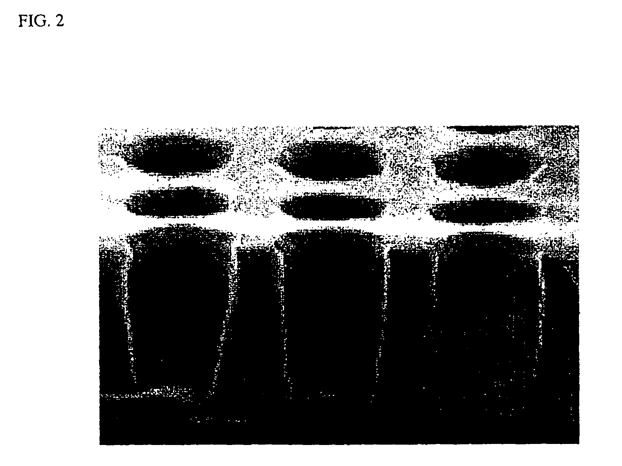

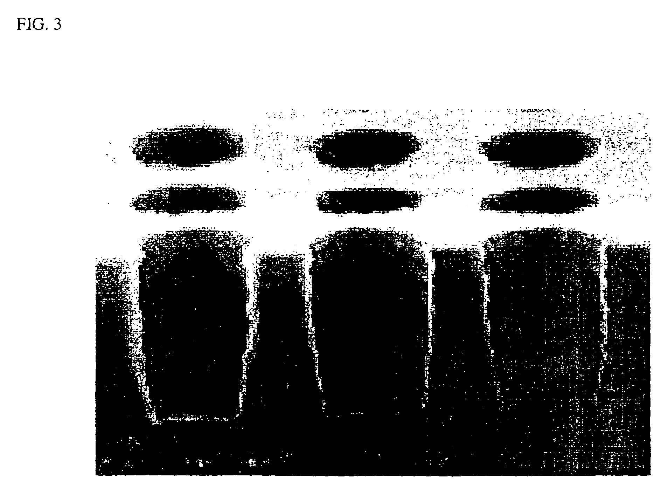

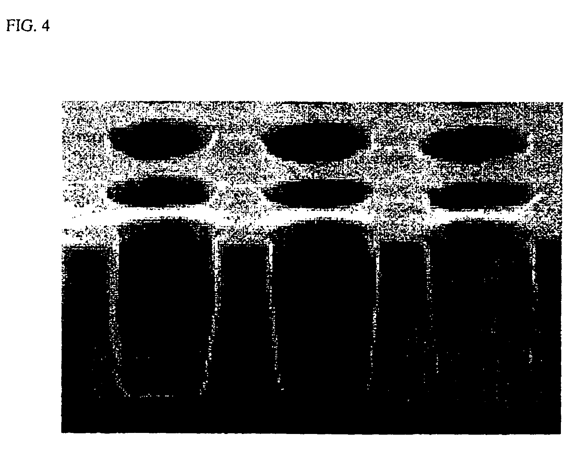

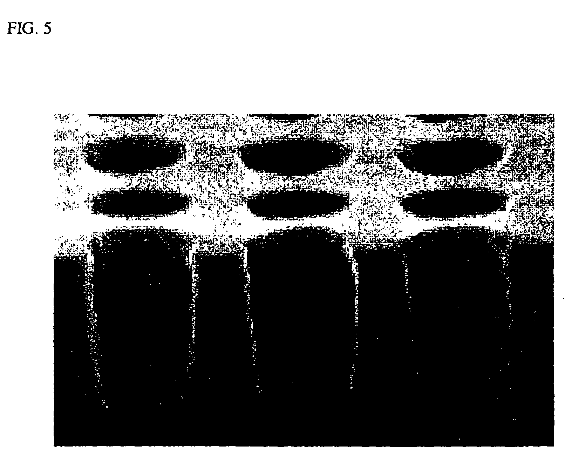

The poisoning or contamination of a photoresist layer is evidenced by reduced resolution of features. For example, Fig. 1 shows a scanning electron micrograph ("SEM") of a cross-sectional image of a contact hole in a dielectric layer formed without the use of a barrier layer. Significant bowing in the bottom of the contact hole can clearly be seen in this figure. When a barrier layer of the present invention is used, the poisoning or contamination of the photoresist layer, as evidenced by bowing, is greatly reduced or eliminated. Fig. 2 shows a SEM of a cross-sectional image of a contact hole in a dielectric layer formed with the use of a 600 Å barrier layer of the present invention. A reduction in the amount of bowing in the bottom of the contact hole as compared to Fig. 1 is clearly visible. Thicker barrier layers of the present invention further reduce such poisoning or contamination. Figures 3 to 5 show a SEM of a cross-sectional image of a contact hole in a dielectric layer formed with the use of a 1000 Å, 1500 Å and 2000 Å thick barrier layer, respectively. As can be seen from Figures 2 through 5, the barrier layers of the present invention significantly reduce the poisoning or contamination of a photoresist layer, as evidenced by bowing,

Thus, the present invention provides a method for manufacturing an electronic device including the steps of: a) providing a dielectric layer on a substrate; b) disposing on a surface of the dielectric layer a barrier composition including one or more cross-linkable polymers, one or more acid catalysts, one or more cross-linking agents and one or more solvents, wherein at least one of the cross-linkable polymers and the cross-linking agent includes one or more acidic moieties; and c) heating the substrate at a temperature sufficient to at least partially cure the barrier composition to form a barrier layer. Typically, a photoresist layer is disposed on the surface of the barrier layer. It is preferred that an antireflective coating is disposed between the surface of the barrier layer and the photoresist layer. It is further preferred that the photoresist layer includes a positive acting photoresist.

Thus, the present invention provides a method for manufacturing an electronic device including the steps of: a) providing a dielectric layer on a substrate; b) disposing on a surface of the dielectric layer a barrier composition including one or more cross-linkable polymers, one or more acid catalysts, one or more cross-linking agents and one or more solvents, wherein at least one of the cross-linkable polymers and the cross-linking agent includes one or more acidic moieties; c) heating the substrate at a temperature sufficient to at least partially cure the barrier composition to form a barrier layer; d) disposing on the surface of the barrier layer an antireflective coating; and e) disposing on the surface of the antireflective coating a photoresist layer.

If a barrier layer of the present invention is used without an antireflective coating, it is preferred that the barrier layer has a thickness of at least about 1000Å, more preferably at least about 1200 Å, and even more preferably at least about 1500 Å. When an antireflective coating is disposed between the barrier layer and the photoresist layer, it is preferred that the barrier layer has a thickness of at least about 400 Å, and more preferably of at least about 600 Å. Typical ranges of barrier thickness are from about 400 to about 2500 Å, preferably from about 600 to about 2000 Å, and more preferably from about 800 to about 1500 Å. In general, antireflective coatings have a thickness of from about 200 to about 2000 Å, and preferably from about 400 to about 1600 Å. Photoresist layers, in general, have a thickness of from about 200 to about 10,000 Å, preferably from about 500 to about 7500 Å.

An advantage of the compositions of the present invention is that they are spin bowl compatible with photoresist and spin-on dielectrics.

Although the invention has been described primarily with respect to semiconductor manufacture, it will be appreciated that the present invention may be used in a wide variety of applications.

The following examples are intended to illustrate further various aspects of the present invention, but are not intended to limit the scope of the invention in any aspect.

### Example 1

A barrier layer composition was prepared by combining a meta-cresol-para-cresol-2,5-dimethoxyphenol novolak polymer (301.268 g of a 30 % solids solution in propylene glycol monomethyl ether acetate ("PGMEA"), 75.95% of solids, Mn 800, Mw 2500 g/mol, Tg 83° C), 9.520 g of a blocked dodecyl benzene sulfonic acid as a thermal acid generator, (Nacure 5225 available from King Industries, Norwalk, Connecticut, as a 25 % solids solution in iso-propanol, 2% of solids), tetrabutoxyglycoluril as cross-linking agent (26.180 g, 22 % of solids), FC430 (available from 3M, Minneapolis, Minnesota) as a surface active leveling agent (5.950 g of a 1% solution in PGMEA, 0.05% solids), dimethyl adipate (5.950 g, 5 % of solids without including it in solids calculation), and 322.512 g of PGMEA. This prepared a 700 g sample at 17 % solids. The composition was rolled for a period sufficient to solubilize the material and filtered through a 0.2 micron poly(tetrafluoroethylene) ("PTFE") filter prior to use.

### Example 2

Four wafers containing a P/CVD dielectric layer (Samples 1-4) were spin coated with various thicknesses of the barrier composition of the Example 1 using a TEL Mark 8. The compositions were baked at 195° C for 60 seconds. A commercially available antireflective coating (AR7, available from Shipley Company, Marlborough, Massachusetts) was spin coated on the surface of the cured barrier composition to provide a thickness of 600 Å and then baked at 175° C for 60 seconds to cure the film.

Four wafers containing the same P/CVD dielectric layer (Comparative Samples C1-C4) were spin coated with the same AR7 antireflective coating at various thicknesses and baked under the same conditions. These comparative samples did not contain any barrier composition.

All the wafers were then spin coated with a commercially available photoresist (UV210, available from Shipley Company). The photoresist was coated to a thickness of 5000 Å and baked at 130° C for 60 seconds. The wafers were then exposed using an ASML 5500/200 tool at 25 mJ/cm² up to 33 mmJ/cm² to prepare 200 nm trenches having an aspect ratio of 1:2. Following exposure, the wafers were baked at 130° C for 90 seconds and then developed. The results are reported in Table 1.

**Table 1**

| Sample | Barrier Composition Thickness (Å) | Antireflective Coating Thickness (Å) | Exposure Results |
|---|---|---|---|
| 1 | 1300 | 600 | Imaged |
| 2 | 1000 | 600 | Imaged |
| 3 | 700 | 600 | Imaged |
| 4 | 400 | 600 | Imaged |
| C-1 | 0 | 1300 | Did not image |
| C-2 | 0 | 1000 | Did not image |
| C-3 | 0 | 1600 | Barely discernible imaging |
| C-4 | 0 | 1900 | Imaged, but not at lowest dose |

The above data clearly show that the barrier compositions of the present invention are effective in reducing or preventing contamination of poisoning of photoresist layers by dielectric layers. Further, when the compositions of the present invention are used, the thickness of any antireflective coating layer may be reduced.

### Example 3

Four wafers having a P/CVD dielectric layer (Samples 5-8) were spin coated with various thicknesses of the barrier composition of the Example 1. The compositions were baked at 205° C for 60 seconds. A commercially available antireflective coating (AR3, available from Shipley Company) was spin coated on the surface of the cured barrier composition to provide a thickness of 600 Å and then baked at 205° C for 60 seconds to cure the film. One wafer (Comparative Sample C-5) containing the same P/CVD dielectric layer was spin coated with the same AR3 antireflective coating at 600Å thickness and baked under the same conditions. This comparative sample did not contain the barrier composition.

Each wafer was then spin coated with a commercially available photoresist (UV200, available from Shipley Company). The photoresist was coated to a thickness of 5000 Å and baked at 140° C for 60 seconds using a proximity hotplate. The wafers were then exposed using an ASML 5500/300 tool to prepare 0.22 µ contact holes. Following exposure, the wafers were baked at 140° C for 90 seconds using a proximity hotplate and then developed. After development, the wafers were examined using scanning electron microscopy ("SEM"). Figures 1-5 show the cross-sectional image of the contact holes formed. The exposure conditions are results are reported in Table 2.

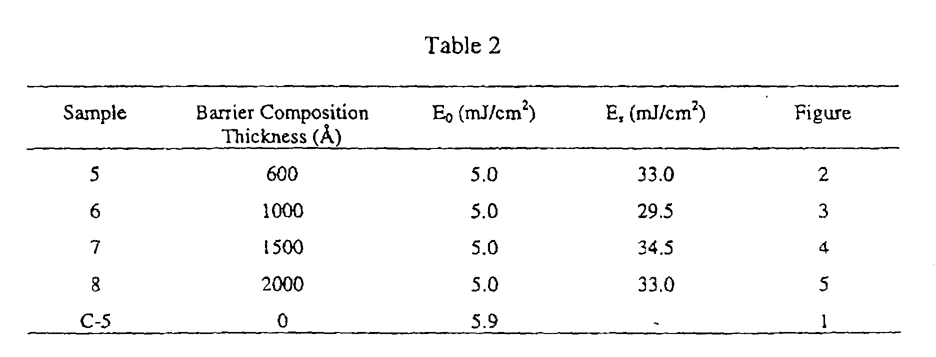

The use of the barrier compositions of the present invention provide contact holes having better sidewall definition and less bowing than those formed without the use of the barrier composition. For example, Figure 1 shows the cross-sectional image of a contact hole from Comparative Sample C-5, which shows significant bowing. In contrast, Figures 2-5 show cross-sectional images of contact holes formed using the barrier compositions of the present invention. In these figures, it can clearly be seen that the contact holes have better sidewall definition and significantly less bowing.

## Claims

1. A barrier composition comprising one or more cross-linkable polymers, one or more acid catalysts, one or more cross-linking agents and one or more solvents, wherein at least one of the cross-linkable polymers and the cross-linking agent comprises one or more acidic moieties.

2. The composition of claim 1 wherein the cross-linkable polymer comprises as polymerized units one or more aromatic hydroxyl compounds.

3. The composition of claim 1 wherein the cross-linkable polymer comprises one or more aromatic-aldehyde condensates.

4. The composition of claim 1 wherein the acidic moieties are at least partially free of blocking groups.

5. The composition of claim 1 wherein the cross-linkable polymer comprises one or more aromatic-aldehyde condensates and one or more (meth)acrylate polymers.

6. A method of providing a barrier layer on a dielectric substrate comprising the step of disposing on the surface of a dielectric substrate a composition comprising one or more cross-linkable polymers, one or more acid catalysts, one or more cross-linking agents and one or more solvents, wherein at least one of the cross-linkable polymers and the cross-linking agent comprises one or more acidic moieties.

7. The method of claim 6 wherein the cross-linkable polymer comprises as polymerized units one or more aromatic hydroxyl compounds.

8. The method of claim 6 wherein the cross-linkable polymer comprises one or more aromatic-aldehyde condensates.

9. The method of claim 6 wherein the acidic moieties are at least partially free of blocking groups.

10. The method of claim 6 wherein the cross-linkable polymer comprises one or more aromatic-aldehyde condensates and one or more (meth)acrylate polymers.

11. The method of claim 6 wherein the dielectric substrate is applied by physical vapor deposition or chemical vapor deposition.

12. The method of claim 6 wherein the dielectric substrate is inorganic.

13. The method of claim 6 wherein the dielectric substrate comprises silicon.

14. A device having a dielectric layer and a barrier layer disposed thereon, wherein the barrier layer comprises one or more cross-linked polymers comprising as polymerized units one or more cross-linkable polymers and one or more cross-linking agents, wherein at least one of the cross-linkable polymers and the cross-linking agent comprises one or more acidic moieties.

15. The device of claim 14 further comprising a photoresist layer.

16. The device of claim 14 further comprising an antireflective coating disposed between the barrier layer and the photoresist layer.

17. The device of claim 14 wherein the barrier layer has a thickness of from about 200 Å to about 1.5 µm.

18. The device of claim 14 wherein the dielectric layer is applied by physical vapor deposition or chemical vapor deposition.

19. The device of claim 14 wherein the dielectric layer is inorganic.

20. The device of claim 14 wherein the dielectric layer comprises silicon.

21. A method of reducing contamination of a photoresist layer comprising the step of disposing a barrier layer between a dielectric layer and the photoresist layer, the barrier layer comprising one or more cross-linked polymers comprising as polymerized units one or more cross-linkable polymers and one or more cross-linking agents, wherein at least one of the cross-linkable polymers and the cross-linking agent comprises one or more acidic moieties.

22. The method of claim 21 wherein the cross-linkable polymer comprises as polymerized units one or more aromatic hydroxyl compounds.

23. The method of claim 21 wherein the cross-linkable polymer comprises one or more aromatic-aldehyde condensates.

24. The method of claim 21 wherein the acidic moieties are at least partially free of blocking groups.

25. The method of claim 21 wherein the cross-linkable polymer comprises one or more aromatic-aldehyde condensates and one or more (meth)acrylate polymers.

26. The method of claim 21 wherein the dielectric layer is inorganic.

27. The method of claim 21 wherein the dielectric layer comprises silicon.

28. The method of claim 21 wherein the barrier layer has a thickness of from about 200 Å to about 1.5 µm.

29. A method for manufacturing an electronic device comprising the steps of: a) providing a dielectric layer on a substrate; b) disposing on a surface of the dielectric layer a barrier composition comprising one or more cross-linkable polymers, one or more acid catalysts; one or more cross-linking agents and one or more solvents, wherein at least one of the cross-linkable polymers and the cross-linking agent comprises one or more acidic moieties; and c) heating the substrate at a temperature sufficient to at least partially cure the barrier composition to form a barrier layer.

30. A method for manufacturing an electronic device comprising the steps of: a) providing a dielectric layer on a substrate; b) disposing on a surface of the dielectric layer a barrier composition comprising one or more cross-linkable polymers, one or more acid catalysts, one or more cross-linking agents and one or more solvents, wherein at least one of the cross-linkable polymers and the cross-linking agent comprises one or more acidic moieties; c) heating the substrate at a temperature sufficient to at least partially cure the barrier composition to form a barrier layer; d) disposing on the surface of the barrier layer an antireflective coating; and e) disposing on the surface of the antireflective coating a photoresist layer.
